# DEMANDE DE BREVET EUROPEEN

(11) **EP 4 783 794 A1**
(43) Date de publication de la demande: **29.07.2026**
(21) Numéro de dépôt: 26152364.1
(22) Date de dépôt: 16.01.2026
(51) Int. Cl.: H10K 30/40, H10K 30/86, H10K 71/16, H10K 30/57, H10K 85/50

(54) **PROCÉDÉ DE FABRICATION D'UN DISPOSITIF OPTOÉLECTRONIQUE**

(30) Priorité: 23.01.2025 FR 2500680
(71) Demandeur: Commissariat à l'Energie Atomique et aux Energies Alternatives, 75015 Paris (FR)
(72) Inventeur: ALCOCER, Kilian, 38054 GRENOBLE CEDEX 09 (FR); DUPONT, Florian, 38054 GRENOBLE CEDEX 09 (FR)
(74) Mandataire: Cabinet Beaumont

(57) **Abrégé**

La présente description concerne un dispositif optoélectronique comprenant une couche en NiOx recouverte et en contact avec une couche de pérovskite, la couche en NiOx étant une couche monolithique avec x compris entre 0,8 et 1,2 et de préférence entre 0,9 et 1,1.

Elle concerne également un procédé de fabrication d'un dispositif optoélectronique comprenant les étapes suivantes :
- déposer une couche en NiOx avec x compris entre 0,8 et 1,2 et de préférence entre 0,9 et 1,1 par ablation laser pulsée à partir d'une cible de NiO en présence de dioxygène ou d'un mélange de gaz contenant du dioxygène, la pression du dioxygène ou du mélange de gaz est étant de plus de 0,01 mbar, et de préférence d'au moins 0,1mbar,
- une étape au cours de laquelle une couche en pérovskite est déposée sur la couche de NiOx.

## Description

### Domaine technique

La présente description concerne de façon générale le domaine des dispositifs optoélectroniques, et plus particulièrement, des dispositifs optoélectroniques comprenant une couche en pérovskite, notamment les cellules photovoltaïques simple jonction ou les cellules photovoltaïques tandem silicium/pérovskite.

### Technique antérieure

Les cellules photovoltaïques à base de pérovskite comprennent une couche en pérovskite disposée entre une couche de transport des électrons (ETL pour 'Electron Transport Layer') et une couche de transport des trous (HTL pour 'Hole Transport Layer'). La couche ETL permet d'extraire les électrons générés par la couche en pérovksite et de les transporter vers une première électrode. La couche HTL permet d'extraire les trous générés par la couche en pérovksite et de les transporter vers une seconde électrode.

Dans les cellules photovoltaïques à base de pérovskite de type p-i-n, la couche de transport de trous est déposée avant la couche de pérovskite. Elle doit présenter un état de surface permettant de déposer facilement la couche de pérovskite.

La couche de transport de trous est souvent en un matériau inorganique, typiquement en oxyde, et notamment en NiOₓ.

La couche de NiOx peut être formée par pulvérisation magnétron radiofréquence (pulvérisation magnétron RF ou RF-MS). Mais les dépôts RF-MS peuvent être relativement lents et les couches déposées nécessitent souvent des traitements supplémentaires (modification de la surface pour améliorer la mouillabilité, recuit et/ou passivation).

Il est également possible de déposer une couche de NiOx par ablation laser pulsé ou PLD ('pulsed laser deposition'). Les vitesses de dépôt sont légèrement améliorées par rapport aux dépôts par RF-MS. Les performances obtenues sont comparables aux performances des couches déposées par RF-MS. Cependant, un traitement supplémentaire (recuit, traitement de surface au plasma ou dopage) est toujours nécessaire. Par exemple, dans l'article de Park et al. ("Efficient CH3NH3PbI3 Perovskite Solar Cells Employing Nanostructured p-Type NiO Electrode Formed by a Pulsed Laser Deposition", Adv. Mater. 2015, 27, 4013-4019), après avoir déposé la couche de NiO par PLD à une pression de dioxygène comprise entre 1,3 Pa et 119 Pa, un traitement thermique à 200°C puis un traitement plasma (argon) sont mis en œuvre avant de déposer la couche de pérovskite.

Actuellement, il n'existe pas de méthode industrialisable pour former rapidement une couche de NiOx présentant de bonnes performances pour des cellules solaires, et notamment des cellules solaires tandem PK/Si.

### Résumé de l'invention

Il existe un besoin d'avoir un procédé de fabrication d'un dispositif optoélectronique comprenant une couche de NiOx de bonne qualité et facilement industrialisable.

Ce but est atteint par un dispositif optoélectronique comprenant une couche en NiOx recouverte et en contact avec une couche de pérovskite, la couche en NiOx étant une couche monolithique avec x compris entre 0,8 et 1,2 de préférence entre 0,9 et 1,1.

Selon un mode de réalisation particulier, la couche en pérovskite est formée d'une pérovskite ayant pour formule ABX₃ avec A représentant un cation organique ou inorganique ou une combinaison de cations métalliques et/ou de cations organiques,
B représentant un ou plusieurs éléments métalliques, tels que le plomb, l'étain, le bismuth et l'antimoine,
X représentant un ou plusieurs anions, en particulier un ou plusieurs halogènes, et plus particulièrement choisis parmi le chlore, le brome, l'iode et leurs mélanges, la pérovskite étant de préférence CsₓFA₁₋ₓPb(I_{y}Br_{1-y})₃ avec, de préférence, x < 0,17 et 0 < y < 1.

Selon un mode de réalisation particulier, le dispositif optoélectronique est une cellule photovoltaïque à simple jonction de type p-i-n, comprenant, par exemple, depuis une face soumise à un rayonnement lumineux :
- un substrat,
- une première électrode,
- la couche en NiOx,
- la couche en pérovskite,
- une couche dopée n,
- une deuxième électrode.

Selon ce mode de réalisation particulier, l'épaisseur de la couche en NiOx est comprise entre 1 et 50 nm, de préférence entre 5 et 20 nm.

Selon un mode de réalisation particulier, le dispositif optoélectronique est une cellule photovoltaïque tandem pérovskite sur silicium de type p-i-n comprenant deux sous-cellules empilées l'une sur l'autre, une première sous-cellule étant une sous-cellule en pérovskite et une deuxième sous-cellule étant une sous-cellule en silicium, par exemple une sous-cellule à hétérojonction de silicium,
la première sous-cellule comprenant, par exemple, depuis une face soumise à un rayonnement lumineux :
- une électrode,
- une couche dopée n,
- la couche en pérovskite,
- la couche en NiOx.

Selon ce mode de réalisation particulier, l'épaisseur de la couche en NiOx est comprise entre 2 et 20 nm, de préférence entre 10 et 20 nm.

Ce but est également atteint par un procédé de fabrication d'un dispositif optoélectronique comprenant les étapes suivantes :
- déposer une couche en NiOx avec x compris entre 0,8 et 1,2 de préférence entre 0,9 et 1,1 par ablation laser pulsé à partir d'une cible de NiO en présence de dioxygène ou d'un mélange de gaz contenant du dioxygène, la pression du dioxygène ou du mélange de gaz étant de plus de 0,01 mbar et, encore plus préférentiellement d'au moins 0,1mbar, et de préférence inférieure ou égale à 0,4 mbar,
- une étape au cours de laquelle une couche en pérovskite est déposée sur la couche de NiOx.

Selon un mode de réalisation particulier, le procédé est réalisé sans traitement intermédiaire entre le dépôt de la couche de NiOx et le dépôt de la couche de pérovskite.

Selon un mode de réalisation particulier, la pression du gaz ou du mélange de gaz est supérieure à 0,01 mbar et inférieure ou égale à 0,4 mbar, de préférence comprise entre 0,07 et 0,3 mbar, et encore plus préférentiellement entre 0,1 et 0,2 mbar.

Selon un mode de réalisation particulier, la fréquence du laser lors du dépôt de la couche en NiOx est comprise entre 10Hz et 300Hz, de préférence entre 50 et 100Hz.

Selon un mode de réalisation particulier, le dispositif optoélectronique est une cellule photovoltaïque de type p-i-n, par exemple une cellule photovoltaïque tandem silicium sur pérovskite ou une cellule photovoltaïque à simple jonction.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique et en coupe, un dispositif optoélectronique, notamment une cellule solaire pérovskite à simple jonction de type p-i-n, selon un autre mode de réalisation particulier de l'invention ;
la figure 2 représente, de manière schématique et en coupe, un dispositif optoélectronique, notamment une cellule solaire tandem pérovskite/silicium de type p-i-n, selon un autre mode de réalisation particulier de l'invention ;
la figure 3 représente l'évolution des rapports atomiques O/Ni quantifiés par spectrométrie de rétrodiffusion Rutherford (RBS) et par spectroscopie photoélectronique X (XPS) ainsi que l'écart VB-WF, en fonction de la pression en O₂, selon un autre mode de réalisation particulier ;
la figure 4 est un graphique représentant l'évolution de la transmission effective et de la résistivité de la couche de NiOx déposé par PLD en fonction de la pression en O₂, selon un mode de réalisation particulier ;
la figure 5 est un graphique représentant les caractéristiques JV ('reverse bias') d'une cellule pérovskite simple jonction, sous éclairement de 1 Soleil AM1.5, avec une couche en NiOx déposée par PLD sous O₂, selon un autre mode de réalisation particulier, et d'une cellule 2PACz donnée à titre comparatif ;
la figure 6 est un graphique représentant les caractéristiques JV ('reverse bias') d'une cellule tandem PK/Si, sous éclairement 1 Soleil AM1.5, avec une couche PLD-NiOx déposée sous O₂, selon un autre mode de réalisation particulier, et d'une cellule 2PACz donnée selon un exemple comparatif ;
la figure 7 est un cliché obtenu au microscope électronique à transmission d'une couche de NiOx monolithique recouverte par une couche de pérovskite, selon un mode de réalisation particulier de l'invention ; et
la figure 8 représente un élargissement (vue A)) sur une partie du cliché de la figure 7 ainsi que des analyses élémentaires en nickel (vue B)), plomb (vue C)), iode (vue D)) et brome (vue E)) réalisées sur l'élargissement de la vue A) .

Les différents éléments ne sont pas nécessairement représentés à une échelle uniforme pour rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 %, de préférence à 5 %.

Par transparent, on entend que la structure ou l'élément considéré a une transmittance supérieure ou égale à 70 %, de préférence supérieure ou égale à 80% et encore plus préférentiellement supérieure ou égale à 90%. La transmittance représente l'intensité lumineuse traversant l'élément ou la structure sur le spectre du visible. Elle peut être mesurée par spectrométrie UV-Vis-IR. La transmittance du spectre du visible correspond à la transmittance pour des longueurs d'ondes comprise entre 350 et 800 nm.

Par compris entre X et Y, on entend que les bornes X et Y sont incluses.

Le procédé qui va être décrit plus en détail par la suite est un procédé de fabrication d'un dispositif optoélectronique 100. Le dispositif comprend au moins une couche en pérovskite (notée PK) 140.

Le dispositif optoélectronique 100 peut être un dispositif choisi parmi :
- un dispositif photovoltaïque : une cellule solaire simple jonction, une cellule solaire en configuration tandem (Silicium / pérovskite, pérovskite / pérovskite, CIGS / pérovskite) ou, de manière plus générale, une cellule solaire multijonction (SI/PK/PK),
- un capteur de lumière comprenant en outre des pérovskites, quantum dots (par exemple PbS), II-VI (par exemple CdTe), CIGS, semiconducteurs couches minces, OLED, ou semiconducteurs organiques,
- un émetteur de lumière : pérovskites, quantum dots (par exemple PbS), II-VI (par exemple CdTe), CIGS, semiconducteurs couches minces, OLED, ou semiconducteurs organiques,
- un dispositif photocatalytique,
- un dispositif pour la photo-électrolyse.

Le procédé de fabrication du dispositif optoélectronique comprend au moins les étapes suivantes :
- une étape au cours laquelle une couche de transport de trous en NiOx 130 (avec x compris entre 0,8 et 1,2, de préférence entre 0,9 et 1,1, par exemple 1,1) est formée par PLD en présence de dioxygène à une pression d'au moins 0,1 mbar, ou d'un mélange de gaz comprenant du dioxygène, le mélange étant à une pression de plus de 0,01 mbar et de préférence d'au moins 0,1 mbar,
- une étape au cours de laquelle la couche active en pérovskite est déposée directement sur la couche NiOx.

Il n'y a pas d'étape intermédiaire entre le dépôt de la couche en NiOx et le dépôt de la couche active. Autrement dit, la couche de NiOx n'est pas soumise à un quelconque traitement (recuit, traitement de surface (greffage de molécules, traitement pour modifier de la balance hydrophile/hydrophobe), dopage, etc). Par recuit, on entend un traitement thermique supérieur ou égal à 200°C, par exemple entre 200 et 500°C.

Le couche en pérovskite 140 est déposée directement sur la couche en NiOx 130 après sa formation.

En effet, l'utilisation d'une pression élevée lors du procédé PLD permet d'obtenir une couche en NiOx 130 monolithique. Par monolithique, on entend que la couche est en seul bloc, homogène. Elle est dense. Elle n'est pas poreuse ni sous forme particulaire ni sous forme d'agrégats. De plus, la couche en NiOx est couvrante (i.e. elle recouvre continument l'élément sur lequel elle est déposée). Elle est également lisse.

Une telle structure permet le dépôt de la couche de pérovskite 140 sans mettre en œuvre de traitement postérieurement au dépôt de la couche de NiOx 130.

De plus, avec un tel procédé, non seulement, la couche de NiOx 130 ne nécessite pas de post-traitement, mais en plus elle peut être déposée, à température ambiante (typiquement entre 20 et 25°C) avec une forte vitesse de dépôt (par exemple entre 1 et 20 nm/min, et notamment entre 1 et 5 nm/min), même pour de grandes surfaces, par exemple sur des plaques de 200 mm.

Un tel procédé est rapide à mettre en œuvre par rapport aux procédés de l'art antérieur et facilement industrialisable.

Nous allons décrire plus en détail l'enchainement des étapes de dépôt de la couche HTL en NiOx 130 et de la couche active en pérovskite 140.

Comme indiqué précédemment, la couche en NiOx 130 est déposée par ablation laser pulsée (PLD). Le dépôt par PLD ('pulsed laser deposition') est une technique de dépôt physique en phase vapeur (PVD), qui consiste à réaliser l'ablation d'un matériau cible (pour les oxydes, la cible est une cible céramique) à l'aide d'un laser pulsé en présence d'un gaz ou d'un mélange de gaz.

Plus précisément, les pulses laser peuvent être des pulses laser nanosecondes (par exemple 15 ns) émis à une fréquence contrôlée (par exemple comprise entre 1 et 300 Hz, de préférence entre 10 et 300Hz, encore plus préférentiellement entre 10 et 100Hz, encore plus préférentiellement entre 20 et 100 Hz et de manière encore plus préférentielle entre 50 et 100 Hz). Les pulses laser sont dirigés vers la cible pour casser les liaisons entre les atomes, qui prennent alors la forme d'une plume de plasma de composition très proche de la cible (transfert stœchiométrique des espèces). La plume, générée perpendiculairement à la cible, en venant au contact d'un substrat choisi, donne lieu à la nucléation d'une couche sur le substrat, dans une chambre (ou enceinte) sous vide à atmosphère contrôlée.

Le laser UV (par exemple un laser UV Excimer KrF à 248 nm) consomme progressivement la cible selon un balayage défini. La plume parcourt le substrat (compatible wafer 300 mm) grâce à une rotation et translation de ce dernier, en le recouvrant uniformément. La fluence du laser (énergie surfacique incidente sur la cible en J/cm²) est gouvernée par la consigne d'énergie des pulses et le focus optique (ce dernier associé à une taille de spot, par exemple, de 5 à 10 mm² sur la cible).

Lors du dépôt, la chambre de dépôt est sous haute pression de gaz (dioxygène) ou de mélange de gaz (du dioxygène et un ou plusieurs autres gaz, par exemple choisis parmi le diazote et l'argon). Par haute pression, on entend ici que la pression du gaz ou du mélange de gaz est, de préférence, supérieure à 0,01 mbar (c'est-à-dire supérieure à 1 Pa) et de préférence supérieure ou égale à 0,07 mbar (c'est-à-dire supérieure à 7 Pa), encore plus préférentiellement supérieure ou égale à 0,1 mbar (c'est-à-dire supérieure à 10 Pa). Elle est, par exemple, comprise entre 0,07 et 0,3 mbar (i.e. entre 7 Pa et 30 Pa), de préférence entre 0,1 et 0,4 mbar (i.e. entre 10 Pa et 40 Pa), encore plus préférentiellement entre 0,1 et 0,3 mbar (i.e. entre 10 Pa et 30 Pa), de manière encore plus préférentielle entre 0,1 et 0,2 mbar (i.e. entre 10 Pa et 20 Pa), par exemple de 0,2 mbar (i.e. 20 Pa).

La combinaison d'une haute pression en gaz ou en mélange de gaz et d'une cible de stœchiométrie contrôlée permet d'obtenir la composition NiOₓ désirée. La cible est, par exemple, en oxyde. L'oxyde peut être NiO ou Ni₂O₃. L'oxygène est, de préférence, apporté majoritairement par la cible.

En particulier, la couche en NiOx est telle que x compris entre 0,9 et 1,1.

Les valeurs de x peuvent être déterminées par XPS (caractérisation en surface) ou RBS (caractérisation dans le volume). On choisira ici une détermination par XPS.

De telles pressions de gaz sont compatibles, d'une part, avec un niveau de vide moins exigeant (souvent reproché aux méthodes de dépôt sous vide), et, d'autre part, avec un procédé PLD capable de vitesses de dépôt élevées et d'une uniformité de dépôt même pour de grandes surfaces.

De telles pressions permettent d'élaborer de façon plus industrialisable les couches de NiOx 130.

De préférence, les couches de NiOx 130 sont déposées à température ambiante (typiquement à une température comprise entre 20 et 25°C). Elles pourraient être déposées à une température supérieure, par exemple à une température pouvant aller jusqu'à 150°C voire jusqu'à 200°C.

Les couches obtenues ainsi obtenues par PLD présentent une faible résistivité et une stœchiométrie adaptée.

L'épaisseur de la couche en NiOx 130 est, par exemple, comprise entre 2 et 50 nm. Dans le cas d'une cellule tandem, l'épaisseur de la couche est, de préférence, comprise entre 2 et 20 nm, encore plus préférentiellement entre 10 et 20 nm. Dans le cas d'une cellule simple jonction, l'épaisseur de la couche est, de préférence, comprise entre 10 et 20 nm.

Les couches obtenues présentent une bonne transparence aussi bien dans la gamme spectrale de la pérovskite (300-750nm) en simple jonction, que dans celle de la sous-cellule silicium en tandem (750-1200nm).

Consécutivement au dépôt de la couche en NiOx 130, la couche active en pérovskite 140 est déposée. Elle peut être déposée par voie gazeuse ou par voie liquide, par exemple avec une méthode de type dépôt à la tournette ('spin-coating'). Une telle méthode de dépôt par voie liquide est facile et rapide à mettre en œuvre, tout en présentant un faible coût d'élaboration.

Il n'y a pas de couches intermédiaires disposées entre la couche en pérovskite 140 et la couche en NiOx 130.

Le procédé est particulièrement intéressant pour fabriquer des cellules simple jonction ou des cellules tandem.

Les cellules photovoltaïques ainsi obtenues sont des cellules présentant une bonne stabilité et un faible courant de fuite au niveau de la jonction (résistance au shunt) . Elles ont de bonnes performances.

Le procédé de fabrication d'une cellule solaire en tandem à base de silicium-pérovskite (Si/PK) ou d'une cellule solaire à simple jonction mettant en œuvre une étape de dépôt d'une couche en NiOx déposée par PLD rend le dispositif très industrialisable.

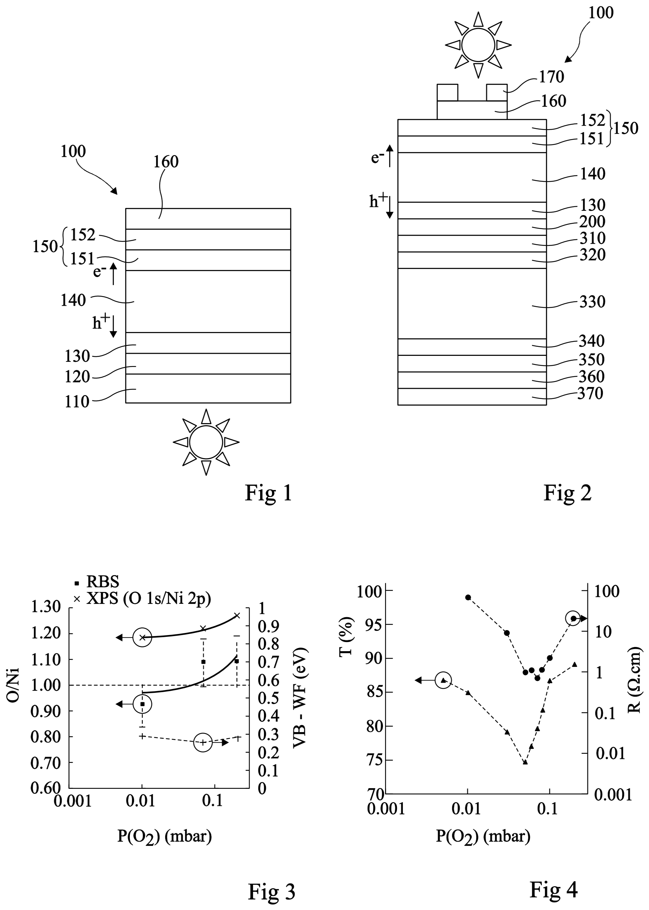

Par exemple, la cellule solaire 100 simple jonction p-i-n comprend successivement depuis la face soumise au rayonnement lumineux (figure 1) :
- un substrat 110, de préférence transparent, par exemple en verre,
- une première électrode 120 dite électrode inférieure, de préférence transparente, par exemple une couche en oxyde transparent conducteur (TCO pour 'Transparent conductive Oxide'), notamment en oxyde d'indium et d'étain (ou ITO pour 'Indium Tin Oxide'),
- une couche conductrice de type p 130 (couche HTL) en NiOx,
- une couche active en pérovskite 140,
- une couche conductrice de type n 151 (aussi appelée couche en transport d'électrons (ETL pour 'Electrons Transport Layer'),
- une deuxième électrode 160 dite électrode supérieure en métal, par exemple en argent ou en aluminium.

Des contacts métalliques, par exemple en Cr/Au, sont formés sur le substrat 110 (non représentés). Ils peuvent être déportés.

L'éclairement se fait à travers le substrat 110.

La couche active 140 est une couche en matériau pérovskite de formule générale ABX₃ avec :
A représentant un cation organique ou inorganique ou une combinaison de cations métalliques et/ou de cations organiques,
B représentant un ou plusieurs éléments métalliques, tels que le plomb (Pb), l'étain (Sn), le bismuth (Bi) et l'antimoine (Sb),
X représentant un ou plusieurs anions, en particulier un ou plusieurs halogènes, plus particulièrement choisis parmi le chlore, le brome, l'iode et leurs mélanges.

De préférence, les pérovskites sont des pérovskites hybrides organiques-inorganiques. Dans de tels matériaux pérovskites, A comprend un ou plusieurs cations organiques peuvent être associés à un ou plusieurs cations métalliques, par exemple du césium et/ou du rubidium. Le ou les cations organiques peuvent être choisis parmi les cations alkyl-ammonium comme (par exemple un cation de type méthylammonium (MA)) et les cations formamidinium (FA).

De préférence, A représente le cation formamidinium (FA), éventuellement associé à du césium ; B est choisi parmi le plomb, l'étain, le bismuth, l'antimoine et leurs mélanges (de préférence le plomb) et X est choisi parmi le chlore, le brome, l'iode et leurs mélanges (de préférence un mélange d'iode et de brome).

Le matériau pérovskite peut être un composé de formule CsₓFA₁₋ₓPb(I_{1-y}Br_{y})₃ avec, par exemple, x < 0,17 ; 0 < y < 1 et FA symbolisant le cation formamidinium ou encore CsₓFA₁₋ₓPbI_{3-y}Br_{y} (avec 0 < y < 1 ou 0 < y < 3).

Le matériau de type n 151 peut être une monocouche. Alternativement, un bicouche 150 peut être utilisé. Il peut s'agir d'un bicouche 150 comprenant une couche dopée n 151, par exemple une couche en fullerène, notamment en fullerène C60, et une couche en tampon, par exemple en BCP (bathocuproine), LiF, ou en oxyde métallique transparent, par exemple en SnO₂.

La cellule solaire tandem silicium pérovskite de type p-i-n est une structure comprenant deux sous-cellules empilées l'une sur l'autre. La sous-cellule supérieure est une sous-cellule en pérovskite tandis que la sous-cellule inférieure est en silicium, notamment il s'agit d'une sous-cellule à hétérojonction de silicium (figure 2).

Les cellules photovoltaïques tandem pérovskite sur silicium pour maximiser l'efficacité de conversion de l'énergie solaire.

Les deux sous-cellules peuvent être séparées par une couche intermédiaire 200 électroniquement conductrice ou semi-conductrice, et de préférence, transparente au rayonnement électromagnétique. Elle peut être en un TCO (oxydes conducteurs transparents) choisis parmi, par exemple, l'ITO (oxyde d'indium-étain), l'AZO (oxyde d'aluminium-zinc), l'IZO (oxyde d'indium-zinc).

La sous-cellule à base de pérovskite comprend successivement depuis la face supérieure face exposée au soleil :
- une électrode dite électrode supérieure 160 de préférence transparente,
- une couche conductrice de type n 151 (aussi appelée couche en transport d'électrons (ETL pour 'Electrons Transport Layer'), ou un bicouche 150 comprenant une couche dopée n 151, par exemple en fullerène, notamment en fullerène C60, et une couche 152, par exemple en BCP ou en SnO₂, en contact avec l'électrode supérieure,
- une couche active en pérovskite 140,
- une couche conductrice de type p 130 (HTL).

Des couches de passivation peuvent être disposées sur et/ou sous la pérovskite. Elles peuvent notamment être en oxyde (Al₂O₃, AlOₓ), ou en pérovskite type 2D. Des bicouches (par exemple NiOx + 2PACz) peuvent être présent au niveau du HTL.

La sous-cellule à hétérojonction de silicium comprend, par exemple, depuis la couche intermédiaire 200 ou depuis la sous-cellule à base de pérovskite :
- une couche en silicium amorphe dopé n 310,
- de préférence une couche à base de silicium amorphe intrinsèque 320 servant de couche en passivation,
- un substrat en silicium cristallin dopé n 330,
- de préférence, une couche à base de silicium amorphe intrinsèque 340 servant de couche en passivation,
- une couche en silicium amorphe dopé p 350,
- une électrode 360, de préférence transparente.

Des contacts métalliques 370, par exemple en Cr/Au, sont formés sur l'électrode 360 de la sous-cellule à base de silicium et d'autres contacts métalliques 170 peuvent être formés sur l'électrode supérieure 160 de la sous-cellule à base de pérovskite. Ils peuvent être déportés au niveau de la face éclairée.

L'éclairement d'un dispositif tandem Si/PK est réalisé à partir de la sous-cellule à base de pérovskite.

Les matériaux précédemment décrit pour la cellule pérovskite simple jonction peuvent être utilisés pour la sous-cellule à base de pérovskite.

L'invention n'est pas limitée aux cellules tandem PK/SI avec une hétérojonction mais pourrait aussi être utilisée pour des cellules tandem PK/PK ou PK/TOPCON par exemple.

### Exemples illustratifs et non limitatifs

Dans ce premier exemple, plusieurs couches de NiOx sont formées par PLD. Différentes pressions en dioxygène ont été testées. La température lors de l'étape de dépôt est la température ambiante. Les rapports atomique O/Ni des différents échantillons ont été déterminé par XPS (0 1s/ Ni 2p) et par RBS (figure 3). La courbe de la figure 3 représente aussi l'écart entre la bande de valence et le travail de sortie (VB-WF) en fonction de la pression en dioxygène utilisée. Les résultats montrent notamment que de forts rapports O/Ni peuvent être obtenus pour des pressions élevées.

La figure 4 représente la transmission effective et la résistivité de la couche en NiOx en fonction de la pression en dioxygène lors du dépôt par PLD. Les pressions élevées en dioxygène conduisent à une bonne transparence et une bonne conductivité.

Ceci confirme que les couches de NiOx peuvent être déposées sous haute pression de dioxygène. Le procédé est industrialisable.

Un dépôt de NiOx a ensuite été intégré en cellule solaire pérovskite simple jonction (par exemple une cellule photovoltaïque en configuration p-i-n telle que représentée sur la figure 1). L'épaisseur de la couche de NiOx est de 10 nm. Elle est déposée par PLD en un temps relativement court (par exemple en 3 min à 50Hz et en 6 min à 50Hz). La surface considérée est ici une plaque de 200 mm de diamètre.

Le procédé de fabrication des cellules simples jonctions peut comprendre les étapes suivantes :
- lavage du substrat (notamment un substrat en verre recouvert d'une couche en ITO),
- dépôt de la couche en type p en NiOx par PLD,
- dépôt de la couche en pérovskite, par dépôt à la tournette puis recuit à 100°C,
- dépôt d'une couche en C60 de 15 nm, par évaporation thermique sous vide,
- dépôt d'une couche de BCP,
- dépôt de l'électrode supérieure d'Ag par évaporation thermique sous vide.

Le dépôt de la couche en NiOx à partir d'une cible NiO et sous haute pression de dioxygène, à température ambiante, peut comprendre au moins les sous-étapes suivantes :
- chargement des substrats/cellules dans l'enceinte,
- isolement de l'enceinte, stabilisation de l'énergie du laser et démarrage de la consigne de pression de travail (haute pression de O₂ : 0,2 mbar à raison d'un flux de 22 sccm ('Standard Cubic Centimeters per Minute') ;
- dépôt de la couche à 50 Hz (50 pulses laser par seconde) ;
- remise à l'équilibre de l'enceinte ;
- déchargement des substrats/cellules.

La couche en NiOx a une épaisseur de 10 nm.

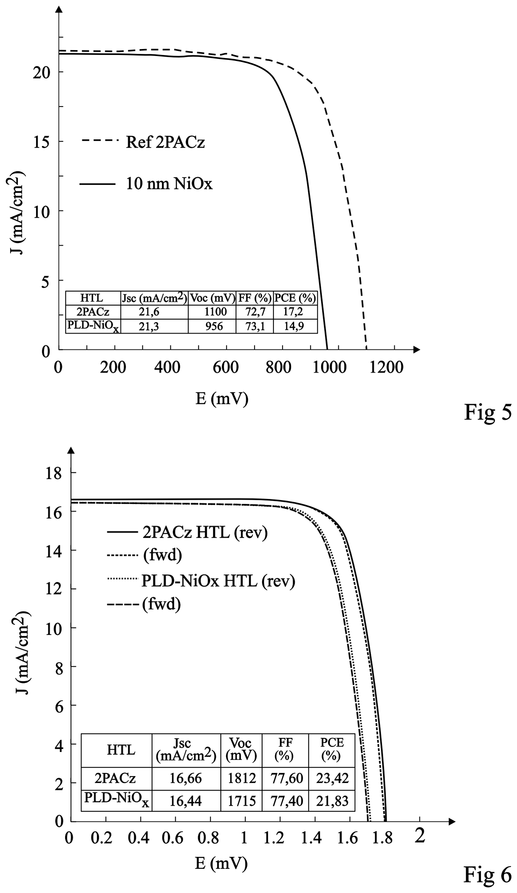

Les performances de la cellule simple jonction obtenue ont été comparées avec une cellule de référence 2PACz (figure 5).

Les cellules solaires de type pérovskite simple jonction de type p-i-n obtenues présentent un rendement photovoltaïque (PCE) de 14,9%, pour une tension de circuit ouvert (V_{oc}) de 956 mV, un courant de court-circuit (J_{sc}) de 21,3 mA/cm² et un facteur de forme (FF) de 73,1 %.

Enfin, l'étude a abouti à l'intégration de la couche en NiOx proposée en cellule tandem p-i-n (comme celle par exemple représentée sur la Figure 2).

Le procédé de fabrication de la cellule tandem peut comprendre les étapes suivantes :
- dépôt de couches de silicium amorphe hydrogéné (passivant) intrinsèques et dopées (a-Si:H), par dépôt chimique en phase vapeur assisté par plasma (PECVD), de part et d'autre d'une plaque de c-Si type n,
- dépôt d'une couche en ITO, par pulvérisation magnétron à courant continu, sur le a-Si:H (p) pour la configuration pi-n, afin de former le contact arrière,
- dépôt d'une fine couche en TCO sur l'a-Si:H (n) pour la configuration p-i-n, pour former la couche en recombinaison entre cellule inférieure et cellule supérieure,

- dépôt d'argent par évaporation thermique pour former un contact en face arrière,
- dépôt d'une couche en NiOx par PLD,
- dépôt d'une couche en pérovskite par dépôt à la tournette et recuit,
- dépôt d'une couche en C60 par évaporation thermique sous vide,
- dépôt d'une couche en BCP,
- dépôt d'une couche en ITO par pulvérisation cathodique ('DC-sputtering'),
- dépôt d'une électrode supérieure en argent par évaporation thermique sous vide.

Les performances de la cellule tandem obtenue a été comparée avec une cellule de référence 2PACz (figure 6).

Les cellules solaires tandem p-i-n pérovskite sur silicium obtenues présentent un rendement photovoltaïque (PCE) de 21,83 %, pour une tension de circuit ouvert (V_{oc}) de 1715 mV, un courant de court-circuit (J_{sc}) de 16,44 mA/cm² et un facteur de forme (FF) de 77,4 %.

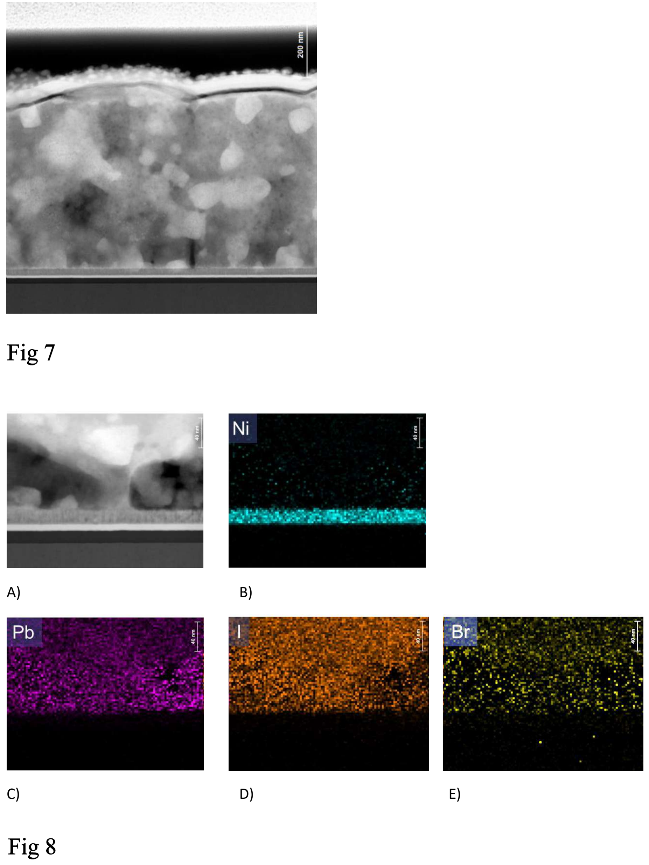

Une observation au microscope électronique à transmission de la cellule tandem permet de confirmer qu'une couche monolithique de NiOx est bien obtenue (figures 7 et 8). La couche de NiOx a une épaisseur de 19 nm. Elle est uniforme et continue. Elle n'est pas mésoporeuse.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Dispositif optoélectronique (100) comprenant une couche en NiOx (130) recouverte et en contact avec une couche de pérovskite (140), la couche en NiOx (130) étant une couche monolithique avec x compris entre 0,8 et 1,2 de préférence entre 0,9 et 1,1.

2. Dispositif selon la revendication précédente, dans lequel la couche en pérovskite (140) est formée d'une pérovskite ayant pour formule ABX₃ avec A représentant un cation organique ou inorganique ou une combinaison de cations métalliques et/ou de cations organiques,
B représentant un ou plusieurs éléments métalliques, tels que le plomb, l'étain, le bismuth et l'antimoine,
X représentant un ou plusieurs anions, en particulier un ou plusieurs halogènes, et plus particulièrement choisis parmi le chlore, le brome, l'iode et leurs mélanges, la pérovskite étant de préférence CsₓFA₁₋ₓPb(I_{y}Br_{1-y})₃ avec, de préférence, x < 0,17 et 0 < y < 1.

3. Dispositif selon l'une des revendications 1 à 2, dans lequel le dispositif optoélectronique (100) est une cellule photovoltaïque à simple jonction de type p-i-n, comprenant, par exemple, depuis une face soumise à un rayonnement lumineux :
- un substrat (110),
- une première électrode (120),
- la couche en NiOx (130),
- la couche en pérovskite (140),
- une couche dopée n (151),
- une deuxième électrode (160).

4. Dispositif selon la revendication précédente, dans lequel l'épaisseur de la couche en NiOx (130) est comprise entre 1 et 50 nm, de préférence entre 5 et 20 nm.

5. Dispositif selon l'une des revendications 1 à 2, dans lequel le dispositif optoélectronique (100) est une cellule photovoltaïque tandem pérovskite sur silicium de type p-in comprenant deux sous-cellules empilées l'une sur l'autre, une première sous-cellule étant une sous-cellule en pérovskite et une deuxième sous-cellule étant une sous-cellule en silicium, par exemple une sous-cellule à hétérojonction de silicium,
la première sous-cellule comprenant, par exemple, depuis une face soumise à un rayonnement lumineux :
- une électrode (160),
- une couche dopée n (151),
- la couche en pérovskite (140),
- la couche en NiOx (130).

6. Dispositif selon la revendication précédente, dans lequel l'épaisseur de la couche en NiOx (130) est comprise entre 2 et 20 nm.

7. Dispositif selon la revendication précédente, dans lequel l'épaisseur de la couche en NiOx (130) est comprise entre 10 et 20 nm.

8. Procédé de fabrication d'un dispositif optoélectronique (100) comprenant les étapes suivantes :
- déposer une couche en NiOx (130) avec x compris entre 0,8 et 1,2 de préférence entre 0,9 et 1,1 par ablation laser pulsé à partir d'une cible de NiO en présence de dioxygène ou d'un mélange de gaz contenant du dioxygène, la pression du dioxygène ou du mélange de gaz étant comprise entre 0,07 mbar et 0,3 mbar,
- une étape au cours de laquelle une couche en pérovskite (140) est déposée sur la couche de NiOx (130), la couche de NiOx (130) n'étant pas soumise à un recuit ou à un traitement de surface entre le dépôt de la couche de NiOx (130) et le dépôt de la couche de pérovskite (140).

9. Procédé selon la revendication 8, dans lequel la pression du gaz ou du mélange de gaz est comprise entre 0,1 et 0,2 mbar.

10. Procédé selon l'une des revendications 8 ou 9, dans lequel la fréquence du laser lors du dépôt de la couche en NiOx (130) est comprise entre 10Hz et 300Hz, de préférence entre 50 et 100Hz.

11. Procédé selon l'une des revendications 8 à 10, dans lequel le dispositif optoélectronique (100) est une cellule photovoltaïque de type p-i-n, par exemple une cellule photovoltaïque tandem silicium sur pérovskite ou une cellule photovoltaïque à simple jonction.
